# EUROPEAN PATENT APPLICATION

(11) **EP 4 513 264 A1**
(43) Date of publication of application: **26.02.2025**
(21) Application number: 22948613.9
(22) Date of filing: 30.06.2022
(51) Int. Cl.: G02F 1/1339, H01L 27/12, H01L 21/82

(54) **DISPLAY SUBSTRATE AND MANUFACTURING METHOD THEREFOR, AND DISPLAY DEVICE**

(71) Applicant: Boe Technology Group Co., Ltd., Beijing 100015 (CN)
(72) Inventor: LIU, Wenqu, Beijing 100176 (CN); ZHANG, Feng, Beijing 100176 (CN); YAO, Qi, Beijing 100176 (CN); YU, Yong, Beijing 100176 (CN); MENG, Detian, Beijing 100176 (CN); CUI, Zhao, Beijing 100176 (CN); LV, Zhijun, Beijing 100176 (CN); YUE, Yang, Beijing 100176 (CN); LI, Yuqiao, Beijing 100176 (CN); HOU, Dongfei, Beijing 100176 (CN); DONG, Liwen, Beijing 100176 (CN); ZHOU, Tianmin, Beijing 100176 (CN)
(74) Representative: Haseltine Lake Kempner LLP
(86) International application number: PCT/CN2022/103116
(87) International publication number: WO 2024/000511

(57) **Abstract**

The present application relates to the technical field of display, and discloses a display substrate and a manufacturing method therefor, and a display device. The display substrate comprises a substrate body, supporting columns, and a protection structure. In any direction parallel to the substrate body, the width of a first surface of each supporting column is approximately equal to the width of a second surface of the supporting column, ensuring that a second surface of the substrate body is a plane. Therefore, during cell-assembly of two display substrates, the surface of a supporting column on one display substrate facing away from a substrate body of the display substrate can be in effective contact with the surface of a supporting column on the other display substrate facing away from a substrate body of the display substrate, and the contact area of the two supporting columns during contact can be determined. In this way, the cell-assembly pressure of the two display substrates during cell-assembly can be accurately calculated, so as to ensure that the cell-assembly effect of the two display substrates is good.

## Description

### TECHNICAL FIELD

The present disclosure relates to the field of display technologies, and in particular, relates to a display substrate and a method for manufacturing the same, and a display device.

### BACKGROUND

With developments of display technologies, and in particular, with rapid developments of virtual reality (VR) and augmented reality (AR) technologies, higher requirements are imposed on display effects of display panels.

The display panel includes: an array substrate and a color film substrate that are opposite, and a liquid crystal layer disposed between the array substrate and the color film substrate. Generally, a plurality of columnar support pillars are disposed between the array substrate and the color film substrate. The support pillar supports the array substrate and the color film substrate, and thus ensures uniformity of a thickness of a liquid crystal display panel.

However, the structure of the support pillar in the current display panel is poor, such that the support effect of the support pillar on the display panel is poor, and thus the display effect of the display panel is poor.

### SUMMARY

Embodiments of the present disclosure provide a display substrate and a method for manufacturing the same, and a display device, which can solve a problem of poor display effect of the display panel in some practices. The technical solutions are as follows.

In a first aspect, a display substrate is provided. The display substrate includes:
a substrate body; and
a plurality of support pillars disposed on the substrate body, wherein the support pillar includes a first surface in contact with the substrate body, and a second surface opposite to the first surface;
wherein in any direction parallel to the substrate body, a ratio of a width of the first surface to a width of the second surface is greater than or equal to 0.8, and is less than or equal to 1.2.

In some embodiments, in the any direction parallel to the substrate body, a ratio of an absolute value of a difference value between the width of the first surface and the width of the second surface to the width of the first surface is less than or equal to 0.4.

In some embodiments, the support pillar includes: a first portion and a second portion that are laminated in a direction perpendicular to and away from the substrate body, wherein an orthogonal projection of the second portion on the substrate body is within an orthogonal projection of the first portion on the substrate body,
a side face of the first portion is a flat surface, and a side face of the second portion is a curved concave surface.

In some embodiments, the absolute value of the difference value between the width of the first surface and the width of the second surface is less than or equal to 0.8 µm.

In some embodiments, an included angle between the side face of the first portion and a face, proximal to the substrate body, of the first portion ranges from 85° to 90°.

In some embodiments, in a direction perpendicular to the side face of the first portion, a maximum depth of the curved concave surface ranges from 0.1 µm to 0.2 µm.

In some embodiments, in the direction perpendicular to the substrate body, a ratio of a thickness of the second portion to a thickness of the first portion ranges from 1/7 to 1/6.

In some embodiments, the display substrate further includes: a protection structure disposed on a side, facing away from the substrate body, of the support pillar, wherein an orthogonal projection of the support pillar on the substrate body is within an orthogonal projection of the protection structure on the substrate body, and
a material of the protection structure is different from a material of the support pillar.

In some embodiments, a hardness of the material of the protection structure is greater than a hardness of the material of the support pillar.

In some embodiments, the material of the protection structure includes an inorganic material, and the material of the support pillar includes an organic material.

In some embodiments, the material of the protection structure includes at least one of a metallic conductive material, a transparent conductive material, and an inorganic insulative material.

In some embodiments, in the direction perpendicular to the substrate body, a thickness of the support pillar ranges from 0.8 µm to 1.5 µm.

In some embodiments, the display substrate is an array substrate, and the substrate body includes: a first base, and a thin-film transistor, a flattening layer, a pixel electrode, and an auxiliary support pillar that are disposed on the first base; wherein
the thin-film transistor is provided with a source and a drain;
the flattening layer is disposed on a side, facing away from the first base, of the thin-film transistor, and is provided with a connection via hole, and at least a portion of the source or the drain is disposed in the connection via hole;
the pixel electrode is disposed on a side, facing away from the first base, of the flattening layer, and a portion of the pixel electrode is disposed in the connection via hole and is in contact with the source or the drain; and
the support pillar is disposed outside the connection via hole, the support pillar and the auxiliary support pillar are integrally formed, and the auxiliary support pillar is disposed in the connection via hole.

In some embodiments, in a direction perpendicular to the first base, a height H of the support pillar and a width W of a face, facing away from the first base, of the support pillar meets: 1/5W≤H≤1/2W.

In some embodiments, the thin-film transistor is further provided with an active layer in contact with the source and the drain; and
the substrate body further includes: a light blocking structure disposed on a side, proximal to the first base, of the thin-film transistor, and a buffer layer disposed between the light blocking structure and the thin-film transistor;
wherein an orthogonal projection of the active layer on the first base is within an orthogonal projection of the light blocking layer on the first base, and an orthogonal projection of the support pillar on the first base is within the orthogonal projection of the light blocking structure on the first base.

In some embodiments, the substrate body further includes: a passivation layer disposed on a side, facing away from the first base, of the pixel electrode, and a common electrode disposed on a side, facing away from the first base, of the passivation layer; wherein a portion of the passivation layer is disposed in the connection via hole, and in the connection via hole, the support pillar is disposed on a side, facing away from the first base, of the passivation layer; and
an orthogonal projection of the common electrode on the first base is not overlapped with an orthogonal projection of the connection via hole on the first base.

In some embodiments, the source and the drain in the thin-film transistor are disposed on different layers.

In some embodiments, the width of the face, facing away from the first base, of the support pillar is less than or equal to 4.5 µm.

In some embodiments, the display substrate is a color film substrate, and the substrate body includes: a second base, and a color resistance layer and a black matrix that are disposed on the second base;
wherein the support pillar is disposed on a side, facing away from the second base, of the black matrix, and an orthogonal projection of the support pillar on the second base is within an orthogonal projection of the black matrix on the second base.

In some embodiments, a width of a face, facing away from the second base, of the support pillar is less than or equal to 2 µm.

In a second aspect, a method for manufacturing a display substrate is provided. The method includes: forming a plurality of support pillars on a substrate body, wherein the support pillar includes a first surface in contact with the substrate body, and a second surface opposite to the first surface;
wherein in any direction parallel to the substrate body, a ratio of a width of the first surface to a width of the second surface is greater than or equal to 0.8, and is less than or equal to 1.2.

In some embodiments, forming the plurality of support pillars on the substrate body includes:
sequentially forming a support film layer and a protection film layer for covering the substrate body on the substrate body, wherein an etching rate on a material forming the protection film layer is less than an etching rate on a material forming the support film layer; and acquiring the support pillar from the support film layer and a protection structure from the protection film layer by simultaneously patterning the support film layer and the protection film layer;
wherein an orthogonal projection of the support pillar on the substrate body is within an orthogonal projection of the protection structure on the substrate body.

In some embodiments, the method further includes:
removing the protection structure upon simultaneously patterning the support film layer and the protection film layer.

In a third aspect, a display device is provided. The display device includes: a power supply assembly, and the display substrate as defined in the first aspect; wherein the power supply assembly is configured to supply power to the display substrate.

The technical solutions in the embodiments of the present disclosure at least have the following beneficial effects.

A display substrate includes: a substrate body and a support pillar. In any direction parallel to the substrate body, the width of the first surface of the support pillar is substantially equal to the width of the second surface of the support pillar, such that the second surface of the substrate body is a flat surface. As such, in attaching the two display substrates, a face, facing away from the substrate body of one display substrate, of the support pillar of the display substrate is efficiently in contact with a face, facing away from the substrate body of the other display substrate, of the support pillar of the other display substrate, and the contact area of the two support pillars is determined. As such, the intensity of pressure of attaching the two display substrates is accurately calculated, such that the attaching effect of the two display substrates is ensured to be great. In this case, the display effect of the display device is great after the two display substrates are subsequently disposed in the display device. In addition, in the case that the attaching effect of the two display substrates is great, the problem of damage of the display substrate caused by great intensity of pressure of attaching in attaching process is avoided, and the problem of great gap between the two display substrates caused by less intensity of pressure of attaching in attaching process is also avoided.

### BRIEF DESCRIPTION OF DRAWINGS

For clearer description of the technical solutions in the embodiments of the present disclosure, the following briefly describes the accompanying drawings required for describing the embodiments. Apparently, the accompanying drawings in the following description show merely some embodiments of the present disclosure, and those of ordinary skill in the art may still derive other drawings from these accompanying drawings without any creative efforts.
FIG. 1 is a schematic structural diagram of a liquid crystal display panel;
FIG. 2 is a schematic diagram of an actual morphology of a first support pillar;
FIG. 3 is a schematic structural diagram of a display substrate according to some embodiments of the present disclosure;
FIG. 4 is an actually schematic structural diagram of a support pillar in a display substrate according to some embodiments of the present disclosure;
FIG. 5 is a schematic structural diagram of film layers of a display substrate according to some embodiments of the present disclosure;
FIG. 6 is a schematic structural diagram of film layers of another display substrate according to some embodiments of the present disclosure;
FIG. 7 is a schematic structural diagram of two substrates upon attaching according to some embodiments of the present disclosure;
FIG. 8 is a schematic structural diagram of film layers of another display substrate according to some embodiments of the present disclosure;
FIG. 9 is a schematic structural diagram of film layers of another display substrate according to some embodiments of the present disclosure;
FIG. 10 is a schematic structural diagram of two substrates upon attaching according to some embodiments of the present disclosure;
FIG. 11 is a flowchart of a method for manufacturing a display substrate according to some embodiments of the present disclosure;
FIG. 12 is a flowchart of another method for manufacturing a display substrate according to some embodiments of the present disclosure;
FIG. 13 is a schematic diagram of forming a support film layer and a protection film layer on a substrate body according to some embodiments of the present disclosure;
FIG. 14 is a schematic diagram of forming a first photoresist pattern on a substrate body according to some embodiments of the present disclosure;
FIG. 15 is a schematic diagram of forming a protection structure on a substrate body according to some embodiments of the present disclosure;
FIG. 16 is a schematic diagram of forming a support pillar on a substrate body according to some embodiments of the present disclosure;
FIG. 17 is a schematic diagram of forming a support pillar and a protection structure on a substrate body according to some embodiments of the present disclosure;
FIG. 18 is a flowchart of another method for manufacturing a display substrate according to some embodiments of the present disclosure;
FIG. 19 is a schematic structural diagram of a gray mask plate according to some embodiments of the present disclosure;
FIG. 20 is a schematic structural diagram of a display substrate upon completing C3 according to some embodiments of the present disclosure;
FIG. 21 is a schematic diagram of forming a support pillar and a protection structure on a substrate body according to some embodiments of the present disclosure;
FIG. 22 is a schematic structural diagram of a display substrate upon completing C501 according to some embodiments of the present disclosure; and
FIG. 23 is a schematic structural diagram of a display substrate upon completing C502 according to some embodiments of the present disclosure.

### DETAILED DESCRIPTION

To make the objectives, technical solutions, and advantages of the present disclosure clearer, the embodiments of the present disclosure are further described in detail hereinafter with reference to the accompanying drawings.

Generally, a display panel is provided with sub-pixels for achieving a display function, and a support pillar for supporting the display panel. The greater the density of the sub-pixels in the display panel, the greater the resolution of the display of the display panel. For example, for the display panel in the VR display device and the AR display device, the pixels per inch (PPI) of the display panel is greater, such that the display panel provides a more real display scene to the user.

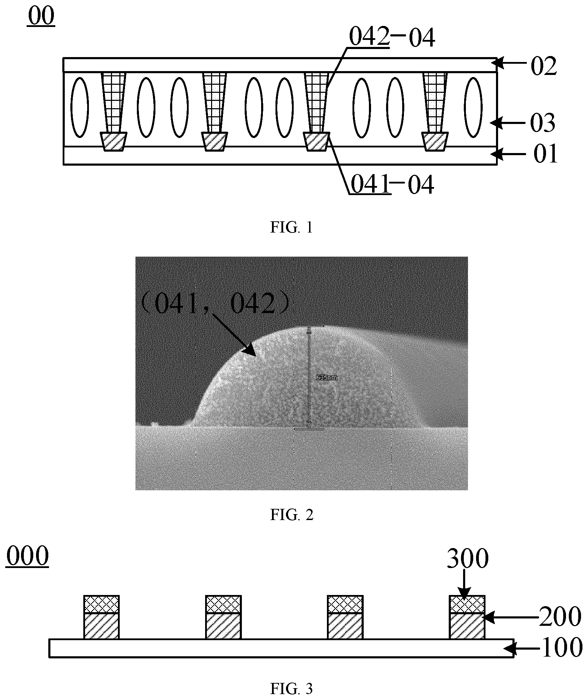

In the case that the display panel is a liquid crystal display panel, referring to FIG. 1, FIG. 1 is a schematic structural diagram of a liquid crystal display panel. The liquid crystal display panel 00 includes: an array substrate 01 and a color film substrate 02 that are opposite to each other, and a liquid crystal layer 03 and a support pillar 04 that are disposed between the array substrate 01 and the color film substrate 02. The support pillar 04 supports the array substrate 01 and the color film substrate 02, and thus ensures uniformity of a thickness of the liquid crystal display panel 00 and avoids scratching surfaces of the array substrate 01 and the color film substrate 02 in attaching the array substrate 01 and the color film substrate 02. Upon a backlight source being disposed on a side, facing away from a display face, of the liquid crystal display panel 00, the liquid crystal display panel 00 supplies an electric signal to the array substrate 01 and the color film substrate 02, such that liquid crystal molecules in the liquid crystal layer 03 respond according to the electric signal. As such, upon light emitted by the backlight source passing through the liquid crystal display panel 00, the liquid crystal display panel 00 displays the screens.

The support pillar 04 includes: a first support pillar 041 and a second support pillar 042. The first support pillar 041 is disposed on a side, proximal to the color film substrate 02, of the array substrate 01, and the second support pillar 042 is disposed on a side, proximal to the array substrate 01, of the color film substrate 02. As such, in attaching the array substrate 01 and the color film substrate 02, a face, facing away from the array substrate 01, of the first support pillar 041 is in contact with a face, facing away from the color film substrate 02, of the second support pillar 042. Thus, the first support pillar 041 and the second support pillar 042 support the liquid crystal display panel 00. The liquid crystal display panel 00 determines an intensity of pressure required for attaching the array substrate 01 and the color film substrate 02 based on a contact area of the first support pillar 041 and the second support pillar 042, a distribution density of the first support pillar 041 and the second support pillar 042, and intensities of pressure that the first support pillar 041 and the second support pillar 042 can withstand respectively, such that the array substrate 01 and the color film substrate 02 are accurately attached.

A resolution of conventional liquid crystal display device is not greater than 300 PPI, and thus sizes of the first support pillar 041 and the second support pillar 042 are great. In some practices, a maximum transverse width of a cross section of the first support pillar 041 in a direction perpendicular to the substrate body is greater than 10 µm, and a face of a side, proximal to the color film substrate, of the first support pillar 041 is a flat structure, that is, approximately parallel to the substrate body. However, it is found by the inventors in practical production that with the increasing of the PPI of the liquid crystal display panel 00, requirements for the resolution of the display device (especially the display device of high PPI), for example, in the VR/AR display technologies, are great, which require to be greater than 1200 PPI. Thus, an area and size of signal pixel are sharply decreased, and the sizes of the first support pillar 041 and the second support pillar 042 in the liquid crystal display panel 00 are reduced to ensure an aperture ratio and transmission of the display device. For example, the maximum transverse width of the first support pillar 041 requires to be less than 5 µm. Referring to FIG. 2, FIG. 2 is a schematic diagram of an actual morphology of a first support pillar. In some practices, the support pillar is manufactured by a lithograph-curing process. As the PPI is increased, the size of the first support pillar requires to be reduced. That is, an area of an orthogonal projection of the first support pillar on the substrate body requires to be reduced. Limited by factors, such as the process precision, properties of materials for manufacturing the support pillar, less spaces between the pixels, and the like, after the first support pillar 041 is manufactured on the array substrate 01 by the one patterning process, a face, facing away from the array substrate 01, of the first support pillar 041 is in an arc-shaped, but not a flat face. Similarly, after the second support pillar 042 is manufactured on the color film substrate 02 by the one patterning process, a face, facing away from the color film substrate 02, of the second support pillar 042 is also in an arc-shaped. In this case, the contact area of the first support pillar 041 and the second support pillar 042 is difficult to determine in attaching the array substrate 01 and the color film substrate 02, such that the intensity of pressure of attaching the array substrate 01 and the color film substrate 02 is difficult to determine. In addition, as the relative faces of the first support pillar 041 and the second support pillar 042 are in the arc-shaped, the contact area is less compared with the flat faces, such that the attaching effect of the array substrate 01 and the color film substrate 02 in the liquid crystal display panel 00 is poor.

For example, the gap between the attached array substrate 01 and color film substrate 02 is great, and the great gap causes that the liquid crystal molecules in the liquid crystal layer 03 cannot work efficiently, such that the display of the high refresh rate of the liquid crystal display panel 00 is not achieved, and the display effect of the liquid crystal display panel 00 is further poor.

Prior to a description of structures and principles of the display substrate in the embodiments of the present disclosure, a description of using scenarios of the display substrate in the embodiments of the present disclosure is first given. Generally, the display panel includes two opposite display substrates, and the two display substrates are supported by the support pillar. In some embodiments, the display panel is the liquid crystal display panel, the organic light-emitting diode display panel, and the like. The present disclosure is illustrated by taking the display panel being the liquid crystal display panel as an example. In the case that the display panel is the liquid crystal display panel, the two opposite display substrates in the display panel are the array substrate and the color film substrate respectively.

Referring to FIG. 3, FIG. 3 is a schematic structural diagram of a display substrate according to some embodiments of the present disclosure. The display substrate 000 includes a substrate body 100 and a plurality of support pillars 200 disposed on the substrate body. The support pillar 100 includes a first surface in contact with the substrate body 100, and a second surface opposite to the first surface.

In any direction parallel to the substrate body 100, a ratio of a width of the first surface to a width of the second surface is greater than or equal to 0.8, and is less than or equal to 1.2.

In this case, in any direction parallel to the substrate body 100, the width of the first surface of the support pillar 100 is substantially equal to the width of the second surface of the support pillar 100, such that the second surface of the substrate body 100 is a flat surface. As such, in attaching the two display substrates 000, a face, facing away from the substrate body 100 of one display substrate 000, of the support pillar 200 of the display substrate 000 is efficiently in contact with a face, facing away from the substrate body 100 of the other display substrate 000, of the support pillar 200 of the other display substrate 000, and the contact area of the two support pillars 200 is determined. As such, the intensity of pressure of attaching the two display substrates 000 is accurately calculated, such that the attaching effect of the two display substrates 000 is ensured to be great. In this case, the display effect of the display device is great after the two display substrates 000 are subsequently disposed in the display device. In addition, in the case that the attaching effect of the two display substrates 000 is great, the problem of damage of the display substrate 000 caused by great intensity of pressure of attaching in attaching process is avoided, and the problem of great gap between the two display substrates 000 caused by less intensity of pressure of attaching in attaching process is also avoided.

In some embodiments, in the any direction parallel to the substrate body 100, a ratio of an absolute value of a difference value between the width of the first surface and the width of the second surface to the width of the first surface is less than or equal to 0.4.

In the embodiments of the present disclosure, the support pillar includes: a first portion and a second portion that are laminated in a direction perpendicular to and away from the substrate body. An orthogonal projection of the second portion on the substrate body is within an orthogonal projection of the first portion on the substrate body.

A side face of the first portion is a flat surface, and a side face of the second portion is a curved concave surface.

In some embodiments, the absolute value of the difference value between the width of the first surface and the width of the second surface is less than or equal to 0.8 µm.

In some embodiments, an included angle between the side face of the first portion and a face, proximal to the substrate body, of the first portion ranges from 85° to 90°.

In some embodiments, in a direction perpendicular to the side face of the first portion, a maximum depth of the curved concave surface ranges from 0.1 µm to 0.2 µm.

In some embodiments, in the direction perpendicular to the substrate body, a ratio of a thickness of the second portion to a thickness of the first portion ranges from 1/7 to 1/6.

In some embodiments, in the direction perpendicular to the substrate body, a thickness of the support pillar ranges from 0.8 µm to 1.5 µm.

In the embodiments of the present disclosure, as shown in FIG. 3, the display substrate further includes: a protection structure 300 disposed on a side, facing away from the substrate body 100, of the support pillar 200. An orthogonal projection of the support pillar 200 on the substrate body 100 is within an orthogonal projection of the protection structure 300 on the substrate body 100, and a material of the protection structure 300 is different from a material of the support pillar 200.

In some embodiments, a hardness of the material of the protection structure 300 is greater than a hardness of the material of the support pillar 200.

In some embodiments, the material of the protection structure 300 includes an inorganic material, and the material of the support pillar 200 includes an organic material.

It should be noted that above support pillar 200 and the protection structure 300 of the display substrate 000 are formed by the one patterning process. For example, a support film layer and a protection film layer are sequentially formed on the substrate body 100, and a photoresist thin film is coated. Then, the photoresist pattern is acquired by respectively exposing and developing the photoresist thin film coated on the display substrate 000 once. Then, portions, without the photoresist pattern, of the support film layer and the protection film layer are etched by an etching process. Eventually, the support pillar 200 and the protection structure 300 on the support pillar 200 are formed in the display substrate 000 by removing the photoresist on the display substrate 000. The support pillar 200 is formed by etching the support film layer, and the protection structure 300 is formed by etching the protection film layer.

In the embodiments of the present disclosure, an etching rate of an etching material (etching gas or liquid) on a material forming the protection structure 300 is less than an etching rate of the etching material on a material forming the support pillar 200. As such, in forming the support pillar 200 and the protection structure 300 by the one patterning process, the etching rate of the etching material on the protection film layer is less, and the etching rate of the etching material on the support film layer is great. Thus, after the portion, without the photoresist pattern, of the support film layer is etched by the etching material, the patterned protection structure 300 is formed in the display substrate 000, and the patterned protection structure 300 is used as a mask, such that the support film layer forms the support pillar 200 under the protection of the protection structure 300. In this process, the protection structure 300 protects the support pillar 200, such that the face, facing away from the substrate body 100, of the support pillar 200 is the flat surface. As such, even though the protection structure 300 on the support pillar 200 is removed subsequently, the two support pillars 200 between the two display substrates 000 are ensured to be efficiently contacted in attaching the two display substrates 000.

In addition, as the etching rate of the etching material on the protection film layer is less, a possibility of arc-shaped face, facing away from substrate body 100, of the protection structure 300 is less in the case that the protection structure 300 on the substrate body 100 is formed by the one patterning process. As such, in attaching the two display substrates 000, the face, facing away from the substrate body 100 of one display substrate 000, of the protection structure 300 of the display substrate 000 is efficiently in contact with the face, facing away from the substrate body 100 of the other display substrate 000, of the protection structure 300 of the other display substrate 000, such that the attaching effect of the two display substrates 000 is ensured to be great. In this case, the display effect of the display device is great after the two display substrates 000 are disposed in the display device.

In the present disclosure, the protection structure 300 is formed by at least one of a metallic conductive material, a transparent conductive material, and an inorganic insulative material. In the case that the protection structure 300 is formed by the metallic insulative material, the metallic insulative material is one or more of aluminum, molybdenum, copper, titanium, and an aluminum-neodymium alloy. In the case that the protection structure 300 is formed by the transparent insulative material, the transparent insulative material is any one or more of an indium gallium zinc oxide (IGZO), an amorphous or polycrystalline zinc oxide (ZnO), an indium zinc oxide (IZO), an indium tin oxide (ITO), a zinc tin oxide (ZTO), a zinc tin oxide (IZTO), a gallium zinc tin oxide (IGZTO), an indium gallium oxide (IGO). In the case that the protection structure 300 is formed by the inorganic insulative material, the inorganic insulative material is at least one of silicon nitride (SiNx, x>0) and silicon oxide (SiOy, y>0). It should be noted that SiNx refers to a substance containing nitrogen in composition and containing elements in any concentration with a range of 10 % to 50% atoms of silicon, a range of 5% to 25% atoms of hydrogen, and a sum of 100% atoms. SiOy refers to a substance containing oxygen in composition, and containing elements in any concentration with a range of 10 % to 50% atoms of silicon, a range of 1% to 25% atoms of hydrogen, and a sum of 100% atoms. In some embodiments, the protection structure 300 contains silicon nitride and silicon oxide.

In the embodiments of the present disclosure, in the case that the protection structure 300 is formed by the metallic insulative material, the protection structure 300 on the display substrate 000 blocks some interference light as the metallic insulative material is lightproof. For example, after the two attached display substrates 000 are subsequently assembled to the liquid crystal display panel, the protection structure 300 blocks some interference light from an external environment and some interference light reflected from thin film transistors in the array substrate. As such, the display effect of the liquid crystal display panel is improved.

In the present disclosure, in the case that the protection structure 300 is formed by the transparent electrode material, and the display substrate 000 includes a common electrode, the protection structure 300 and the common electrode are disposed on the same layer of the same material. That is, the protection structure 300 and the common electrode are formed by the one patterning process. The one patterning process generally includes photoresist coating, exposing, developing, etching, and photoresist removing. As such, the manufacturing process of the display substrate 000 is simplified.

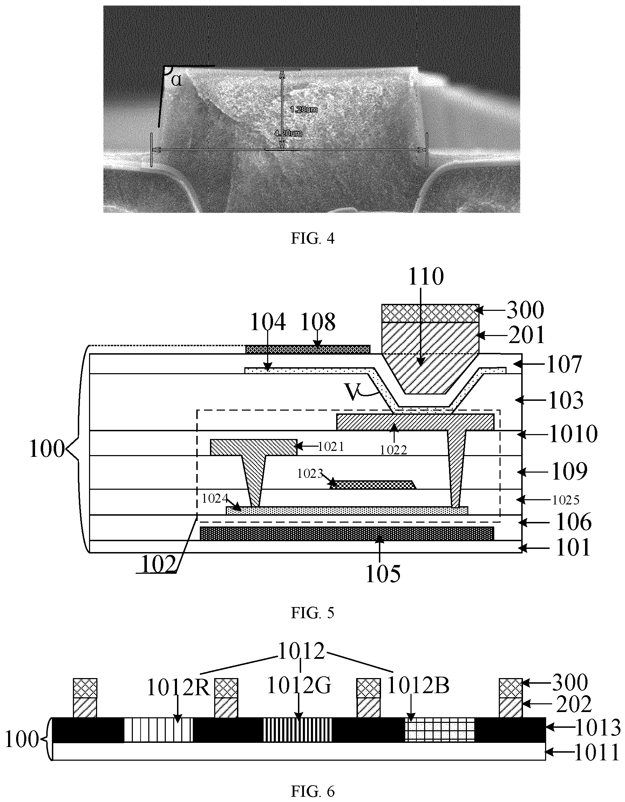

In the embodiments of the present disclosure, as shown in FIG. 4, FIG. 4 is an actually schematic structural diagram of a support pillar in a display substrate according to some embodiments of the present disclosure. An included angle α between a side face of the support pillar 200 of the display substrate 000 and a face, facing away from the substrate body 100, of the support pillar 200 ranges from 90° to 95°. As the included angle between the side face of the support pillar 200 and the face, facing away from the substrate body 100, of the support pillar 200 is an obtuse angle, a width of the face, facing away from the substrate body 100, of the support pillar 200 is great. Thus, the contact area of the support pillar 200 and the face, proximal to the substrate body 100, of the protection structure 300 is great. As such, even though the protection structure 300 on the support pillar 200 is removed, the two support pillars 200 between the two display substrates 000 are ensured to be efficiently contacted in attaching the two display substrates 000.

In the present disclosure, in the case that the display panel formed by attaching the two display substrates 000 is the liquid crystal display panel, the display substrate 000 is an array substrate or a color film substrate. For convenient description hereinafter, the support pillar 200 in the display substrate 000 is referred to as a first support pillar 201 in the case that the display substrate 000 is the array substrate, and the support pillar 200 in the display substrate 000 is referred to as a second support pillar 202 in the case that the display substrate 000 is the color film substrate. The embodiments of the present disclosure are described in above two cases.

In a first case, in the case that the display substrate 000 is the array substrate of the liquid crystal display panel, referring to FIG. 5, FIG. 5 is a schematic structural diagram of film layers of a display substrate according to some embodiments of the present disclosure. The display substrate 000 is the array substrate, and the substrate body 100 includes: a first base 101, and a thin-film transistor 102, a flattening layer 103, a pixel electrode 104, and an auxiliary support pillar 110 that are disposed on the first base 101.

The thin-film transistor 102 is provided with a source 1021 and a drain 1022. The thin-film transistor 102 is further provided with a gate 1023, and the gate 1023 is insulated from the source 1021 and the drain 1022. The thin-film transistor 102 is a top-gate thin film transistor. In some embodiments, the thin-film transistor 102 is a bottom-gate thin film transistor, which is not limited in the embodiments of the present disclosure.

The flattening layer 103 is disposed on a side, facing away from the first base 101, of the thin-film transistor 102, and is provided with a connection via hole V, and at least a portion of the source 1021 or the drain 1022 is disposed in the connection via hole V.

The pixel electrode 104 is disposed on a side, facing away from the first base 101, of the flattening layer 103, and a portion of the pixel electrode 104 is disposed in the connection via hole V, and is in contact with the source 1021 or the drain 1022. FIG. 5 shows a case where the drain 1022 of the thin-film transistor 102 is in contact with pixel electrode 104 in the connection via hole V.

In the embodiments of the present disclosure, at least a portion of the support pillar 200 is disposed outside the connection via hole V, the support pillar 200 and the auxiliary support pillar 100 are integrally formed, and the auxiliary support pillar 110 is disposed in the connection via hole V. As such, an orthogonal projection of the first support pillar 201 on the first base 101 is within an orthogonal projection of the pixel electrode 104 on the first base 101, and the orthogonal projection of the first support pillar 201 on the first base 101 is overlapped with the drain 1022 of the thin-film transistor 102.

In some embodiments, in a direction perpendicular to the first base 101, a height H of the support pillar 200 and a width W of a face, facing away from the first base 101, of the support pillar 200 meets: 1/5W≤H≤1/2W.

In the present disclosure, as shown in FIG. 5, the thin-film transistor 102 is further provided with an active layer 1024 in contact with the source 1021 and the drain 1022. The source 1021 and the drain 1022 of the thin-film transistor 102 are in contact with the active layer 1024 through the via hole. In addition, the active layer 1024 is insulated from the gate through a gate insulation layer 1025.

The substrate body 100 further includes: a light blocking structure 105 disposed on a side, proximal to the first base 101, of the thin-film transistor 102, and a buffer layer 106 disposed between the light blocking structure 105 and the thin-film transistor 102. The light blocking structure 105 is formed by a metal material.

An orthogonal projection of the active layer 1024 on the first base 101 is within an orthogonal projection of the light blocking layer 105 on the first base 101, and an orthogonal projection of the support pillar 201 on the first base 101 is within the orthogonal projection of the light blocking structure 105 on the first base 101. In this case, after the display substrate 000 and the backlight source are assembled subsequently, the light blocking structure 105 blocks interference light from the backlight source and interference light from the external environment, such that the active layer 1024 of the thin-film transistor 102 is not affected by the interference light and effects normally.

In the embodiments of the present disclosure, as shown in FIG. 5, the substrate body 100 further includes: a passivation layer 107 disposed on a side, facing away from the first base 101, of the pixel electrode 104, and a common electrode 108 disposed on a side, facing away from the first base 101, of the passivation layer 107.

A portion of the passivation layer 107 is disposed in the connection via hole V, and in the connection via hole V, the support pillar 201 is disposed on a side, facing away from the first base 101, of the passivation layer 107.

An orthogonal projection of the common electrode 108 on the first base 101 is not overlapped with an orthogonal projection of the connection via hole V on the first base 101. As such, the connection via hole V in the substrate body 100 does not affect the common electrode 108.

In the embodiments of the present disclosure, the source 1021 and the drain 1022 in the thin-film transistor 102 are disposed on different layers. The substrate body 100 further includes: a first insulation layer 109 disposed between the gate 1023 and the source 1021, and a second insulation layer 1010 disposed between the source 1021 and the drain 1022. The source 1021 and the drain 1022 are disposed on different layers by the second insulation layer 1010. A connected via hole is present in the gate insulation layer 1025 and the first insulation layer 109, and the source 1021 of the thin-film transistor 102 and the active layer 1024 are in contact by the connected via hole in the gate insulation layer 1025 and the first insulation layer 109. A connected via hole is also present in gate insulation layer 1025, the first insulation layer 109, and the second insulation layer 1010, and the drain 1022 of the thin-film transistor 102 and the active layer 1024 are in contact by the connected via hole in the gate insulation layer 1025, the first insulation layer 109, and the second insulation layer 1010.

In the present disclosure, the orthogonal projection of the pixel electrode 104 on the first base 101 is the size of the sub-pixel in the display substrate 000. The position of the thin-film transistor 102 of the display substrate 000 is a portion for controlling the sub-pixels in the display substrate 000 to work. As such, the area of the orthogonal projection of the thin-film transistor 102 of the display substrate 000 on the first base 101 is less, such that the sub-pixels in the display substrate 000 for displaying is great. As such, the source 1021 and the drain 1022 of the thin-film transistor 102 are disposed on different layers to avoid a short circuit between the source 1021 and the drain 1022, such that the thin-film transistor 102 in the display substrate 000 works normally.

In some embodiments of the present disclosure, the width of the face, facing away from the first base 101, of the support pillar 200 of the display substrate 000 is less than or equal to 4.5 µm. In the case that the display substrate 000 is the array substrate, a width of a face, facing away from the first base 101, of the first support pillar 201 of the display substrate 000 is less than or equal to 4.5 µm.

In a second case, in the case that the display substrate 000 is the color film substrate of the liquid crystal display panel, referring to FIG. 6, FIG. 6 is a schematic structural diagram of film layers of another display substrate according to some embodiments of the present disclosure. The display substrate 000 is the color film substrate, and the substrate body 100 includes: a second base 1011, and a color resistance layer 1012 and a black matrix 1013 that are disposed on the second base 1011.

The support pillar 200 is disposed on a side, facing away from the second base 1011, of the black matrix 1013, and an orthogonal projection of the support pillar 200 on the second base 1011 is within an orthogonal projection of the black matrix 1013 on the second base 1011. After the two display substrates 000 are attached, the black matrix 1013 blocks interference light from the environment, such that the display effect of the display panel formed by the two display substrates 000 is great. The color resistance layer 1012 includes a red color resistance block 1012R, a green color resistance block 1012G, and a blue color resistance block 1012B. After the two display substrates 000 are subsequently assembled in the display device, the light transmits the color resistance blocks in the color resistance layer 1012, such that the display device displays colorful screens.

In the embodiments of the present disclosure, a width of a face, facing away from the second base 1011, of the support pillar 200 is less than or equal to µm. In the case that the display substrate 000 is the color film substrate, the width of the face, facing away from the second base 1011, of the second support pillar 202 of the display substrate 000 is less than or equal to 2 µm.

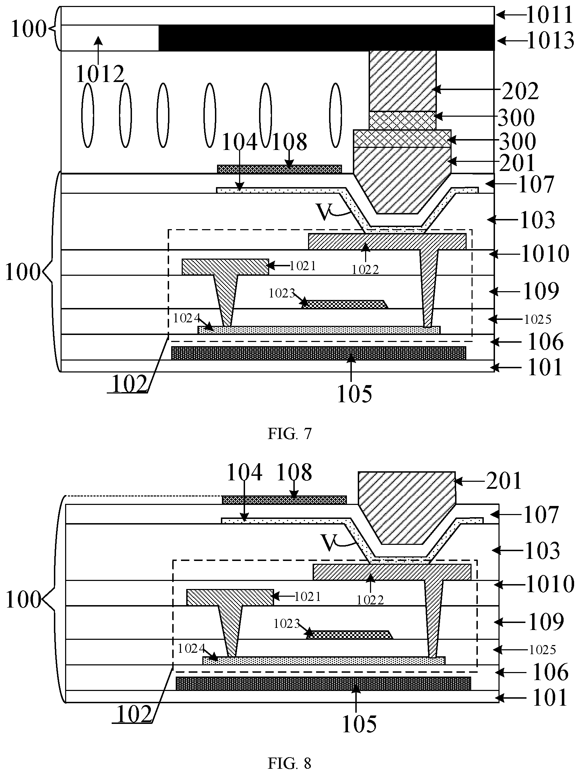

For the above two display substrates 000, one display substrate 000 being the color film substrate and the other display substrate 000 being the array substrate are attached, and a liquid crystal layer is poured between the two attached display substrates 000, such that the liquid crystal display panel is formed. For clearer liquid crystal display panel formed by attaching the two display substrates 000, referring to FIG. 7, FIG. 7 is a schematic structural diagram of two substrates upon attaching according to some embodiments of the present disclosure. The face, facing away from the array substrate, of the first support pillar 201 on the array substrate is in close contact with the face, facing away from the color film substrate, of the second support pillar 202 on the color film substrate. As such, the first support pillar 201 and the second support pillar 202 interact to form the support pillar 200 to support the liquid crystal display panel. In addition, in attaching the array substrate and the color film substrate, the first support pillar 201 and the second support pillar 202 are also configured to avoid scratching the structures of the array substrate and the color film substrate, such that the display effect of the liquid crystal display panel is great.

It should be noted that the width of the face, facing away from the first base 101, of the first support pillar 201 on the array substrate is greater than the width of the face, facing away from the second base 1011, of the second support pillar 202 on the color film substrate. As such, in attaching the array substrate and the color film substrate, the contact area of the face, facing away from the array substrate, of the first support pillar 201 and the face, facing away from the color film substrate, of the second support pillar 202 is ensured to be great by adjusting the position of the second support pillar 202 on the color film substrate.

In summary, a display substrate is provided in the embodiments of the present disclosure. The display substrate includes: a substrate body, a support pillar, and a protection structure. As the support pillar of the display substrate is provided with the protection structure, and a face, facing away from the substrate body, of the protection structure is a flat surface, in attaching the two display substrates, a face, facing away from the substrate body of one display substrate, of the protection structure of the display substrate is efficiently in contact with a face, facing away from the substrate body of the other display substrate, of the protection structure of the other display substrate, and the contact area of the two protection structures is determined. As such, the intensity of pressure is accurately calculated in attaching the two display substrates, such that the attaching effect of the two display substrates is ensured to be great. In this case, the display effect of the display device is great after the two display substrates are subsequently disposed in the display device. In addition, in the case that the attaching effect of the two display substrates is great, the problem of damage of the display substrate caused by great intensity of pressure of attaching in attaching process is avoided, and the problem of great gap between the two display substrates caused by less intensity of pressure of attaching in attaching process is also avoided.

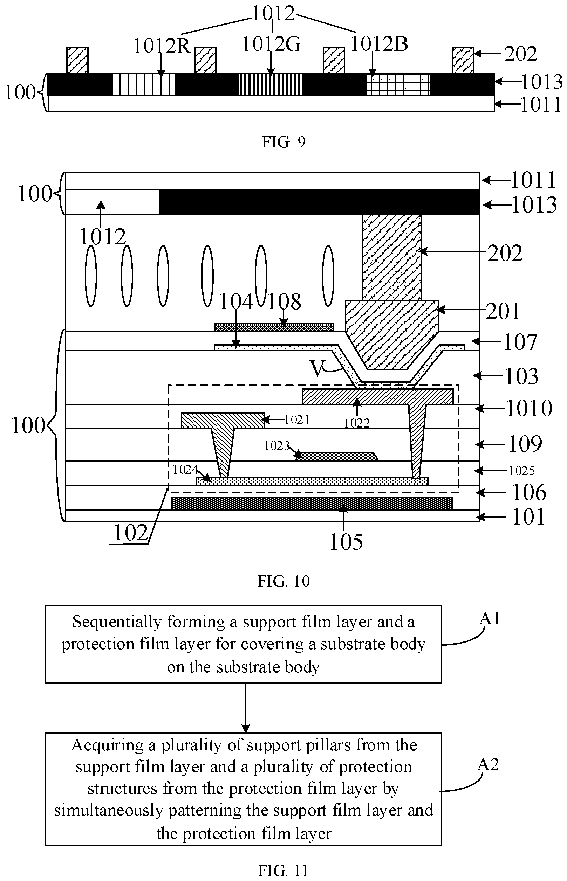

In the embodiments of the present disclosure, referring to FIG. 8 and FIG. 9, FIG. 8 is a schematic structural diagram of film layers of another display substrate according to some embodiments of the present disclosure, and FIG. 9 is a schematic structural diagram of film layers of another display substrate according to some embodiments of the present disclosure. The display substrate 000 includes: a substrate body 100, and a plurality of support pillars 200 disposed on the substrate body 100.

An included angle α between a side face of the support pillar 200 and a face, facing away from the substrate body 100, of the support pillar 200 ranges from 90° to 95°.

It should be noted that the specific structures and beneficial effects of the display substrate 000 shown in FIG. 8 and FIG. 9 refer to description in above embodiments, which are not repeated in the present disclosure.

The display substrate 000 shown in FIG. 8 is the array substrate, and its structure and the structure of the substrate shown in FIG. 5 are substantially the same and only differ in that the protection structure 300 is removed in forming the display substrate 000 shown in FIG. 8. Similarly, the display substrate 000 shown in FIG. 9 is the color film substrate, and its structure and the structure of the substrate shown in FIG. 6 are substantially the same and only differ in that the protection structure 300 is also removed in forming the display substrate 000 shown in FIG. 9. In some embodiments of the present disclosure, the array substrate shown in FIG. 8 and the color film substrate shown in FIG. 9 are attached to form the liquid crystal display panel. Referring to FIG. 10, FIG. 10 is a schematic structural diagram of two substrates upon attaching according to some embodiments of the present disclosure. A face, facing away from the first base 101, of the first support pillar 201 and a face, facing away from the second base 201, of the second support pillar 202 are efficiently contacted, and a contact area of the two is calculated. As such, the intensity of pressure of attaching in attaching the array substrate and the color film substrate is calculated, such that the attaching effect of the array substrate and the color film substrate is ensured to be great.

A method for manufacturing a display substrate is provided in the embodiments of the present disclosure. The method includes: forming a plurality of support pillars on a substrate body. The support pillar includes a first surface in contact with the substrate body, and a second surface opposite to the first surface.

In any direction parallel to the substrate body, a ratio of a width of the first surface to a width of the second surface is greater than or equal to 0.8, and is less than or equal to 1.2.

In some embodiments, forming the plurality of support pillars on the substrate body includes:
sequentially forming a support film layer and a protection film layer for covering the substrate body on the substrate body, wherein an etching rate on a material forming the protection film layer is less than an etching rate on a material forming the support film layer; and acquiring the support pillar from the support film layer and a protection structure from the protection film layer by simultaneously patterning the support film layer and the protection film layer; wherein an orthogonal projection of the support pillar on the substrate body is within an orthogonal projection of the protection structure on the substrate body.

In some embodiments, the method further includes:
removing the protection structure upon simultaneously patterning the support film layer and the protection film layer.

A method for manufacturing a display substrate is further provided in the embodiments of the present disclosure. The method for manufacturing the display substrate is applicable to manufacturing the display substrate shown in above embodiments. For example, the display substrate manufactured by the method for manufacturing the display substrate is the display substrate shown in FIG. 3. Referring to FIG. 11, FIG. 11 is a flowchart of a method for manufacturing a display substrate according to some embodiments of the present disclosure. The method for manufacturing the display substrate includes the following processes.

In A1, a support film layer and a protection film layer for covering a substrate body are sequentially formed on the substrate body.

In A2, a plurality of support pillars from the support film layer and a plurality of protection structures from the protection film layer are acquired by simultaneously patterning the support film layer and the protection film layer.

The plurality of support pillars and the plurality of protection structures are in one-to-one correspondence, and an orthogonal projection of the support pillar on the substrate body is within an orthogonal projection of the corresponding protection structure on the substrate body. As such, a width of a face, facing away from the substrate body, of the protection structure is great.

In summary, in the method for manufacturing the display substrate in the embodiments of the present disclosure, by disposing a protection film layer on the support film layer, an orthogonal projection of the support pillar, formed by the one patterning process, on the substrate body is within an orthogonal projection of the corresponding protection structure on the substrate body. That is, a face, facing away from the substrate body, of the protection structure is a flat surface. In attaching the two display substrates, a face, facing away from the substrate body of one display substrate, of the protection structure of the display substrate is efficiently in contact with a face, facing away from the substrate body of the other display substrate, of the protection structure of the other display substrate, and the contact area of the two protection structures is determined. As such, the attaching effect of the two display substrates is ensured to be great, and the display effect of the display device is great after the two display substrates are subsequently disposed in the display device.

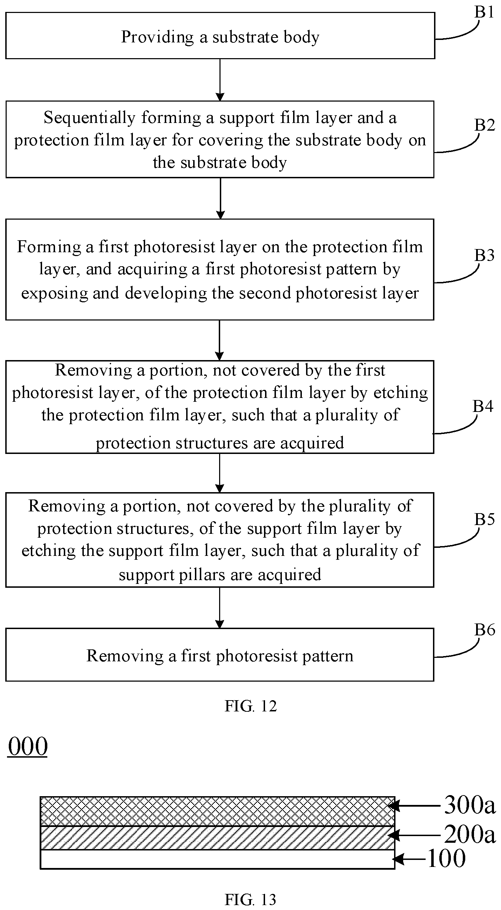

Referring to FIG. 12, FIG. 12 is a flowchart of another method for manufacturing a display substrate according to some embodiments of the present disclosure. For example, the display substrate manufactured by the method for manufacturing the display substrate is the display substrate shown in FIG. 3, 5, 6, 8, or 9. The method for manufacturing the display substrate includes the following processes.

In B1, a substrate body is provided.

In the embodiments of the present disclosure, as the display substrate is an array substrate or a color film substrate, the substrate body is a structure, without a support pillar, in the array substrate, or a structure, without a support pillar, in the color film substrate.

In B2, a support film layer and a protection film layer for covering a substrate body are sequentially formed on the substrate body.

In the embodiments of the present disclosure, the support film layer is formed on the substrate body by any one of depositing, coating, sputtering, and the like. The support film layer is then cured, and the protection film layer is formed on the cured support film layer by any one of depositing, coating, sputtering, and the like. The support film layer is formed by an organic material, and the protection film layer is formed by at least one of a metallic insulative material, a transparent insulative material, and an inorganic insulative material.

In the embodiments of the present disclosure, referring to FIG. 13, FIG. 13 is a schematic diagram of forming a support film layer and a protection film layer on a substrate body according to some embodiments of the present disclosure. A support film layer 200a is formed on the substrate body, and a protection film layer 300a is formed on the support film layer 200a.

In B3, a first photoresist layer is formed on the protection film layer, and a first photoresist pattern is acquired by exposing and developing the first photoresist layer.

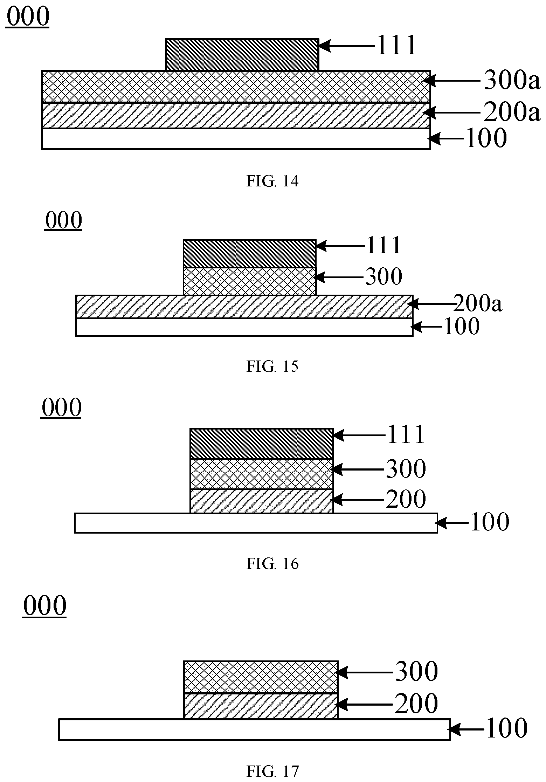

In the embodiments of the present disclosure, referring to FIG. 14, FIG. 14 is a schematic diagram of forming a first photoresist pattern on a substrate body according to some embodiments of the present disclosure. A first photoresist layer is coated on the protection film layer 300a of the substrate body 100, and a first photoresist pattern 111 is acquired by exposing and developing the first photoresist layer once.

In B4, a portion, not covered by the first photoresist layer, of the protection film layer is removed by etching the protection film layer, such that the plurality of protection structures are acquired.

In the embodiments of the present disclosure, referring to FIG. 15, FIG. 15 is a schematic diagram of forming a protection structure on a substrate body according to some embodiments of the present disclosure. The portion, not attached with the photoresist pattern, of the display substrate 000 is etched by the etching process, such that the protection film layer 300a corresponding to the portion not attached with the photoresist pattern is etched, that is, the patterned protection structure 300 is formed. In addition, as the etching rate of the etching material on the protection film layer 300a is less, a possibility of arc-shaped face, facing away from substrate body 100, of the protection structure 300 is less in the case that the protection structure 300 is formed by the one patterning process.

In B5, a portion, not covered by the plurality of protection structures, of the support film layer is removed by etching the support film layer 200a, such that the plurality of support pillars are acquired.

In the embodiments of the present disclosure, referring to FIG. 16, FIG. 16 is a schematic diagram of forming a support pillar on a substrate body according to some embodiments of the present disclosure. A portion, not covered by the protection structure 300, of the display substrate 000 is etched by the etching process, such that the support pillar is formed. In the process, the first photoresist pattern 111 and the protection structure 300 are taken as the mask plate of the support pillar 200 formed by patterning. As the etching rate of the etching material on the protection structure 300 is less, the protection structure 300 protects the support pillar 200, such that the included angle between the side face of the support pillar 200 and the face, facing away from the substrate body 100, of the support pillar 200 ranges from 90° to 95°.

In B6, the first photoresist pattern is removed.

In the embodiments of the present disclosure, referring to FIG. 17, FIG. 17 is a schematic diagram of forming a support pillar and a protection structure on a substrate body according to some embodiments of the present disclosure. The plurality of support pillars 200 and the plurality of protection structures 300 are acquired by removing the photoresist on the display substrate 000.

It should be noted that the plurality of protection structures 300 on the plurality of support pillars 200 are removed or not removed after B6. In the case that the plurality of protection structures 300 on the plurality of support pillars 200 are removed after B6, the structure of the display substrate manufactured by the method for manufacturing the display substrate refers to FIG. 8 or FIG. 9. In the case that the plurality of protection structures 300 on the plurality of support pillars 200 are not removed after B6, the structure of the display substrate manufactured by the method for manufacturing the display substrate refers to FIG. 3, FIG. 5, or FIG. 6.

In summary, in the method for manufacturing the display substrate in the embodiments of the present disclosure, a support film layer and a protection film layer are sequentially formed on the substrate body, and the one patterning process is performed on the substrate body including the support film layer and the protection film layer once. As the etching rate of the etching material on the protection structure is less, a face, facing away from the substrate body, of the protection structure is a flat surface. In attaching the two display substrates, a face, facing away from the substrate body of one display substrate, of the protection structure of the display substrate is efficiently in contact with a face, facing away from the substrate body of the other display substrate, of the protection structure of the other display substrate. In addition, as a face, facing away from the substrate body, of the support pillar is a flat surface, an efficient contact between the two support pillars between the two display substrates is ensured in attaching the two display substrates even though the protection structure on the support pillar is removed. As such, the attaching effect of the two display substrates is ensured to be great, and the display effect of the display device is great after the two display substrates are subsequently disposed in the display device.

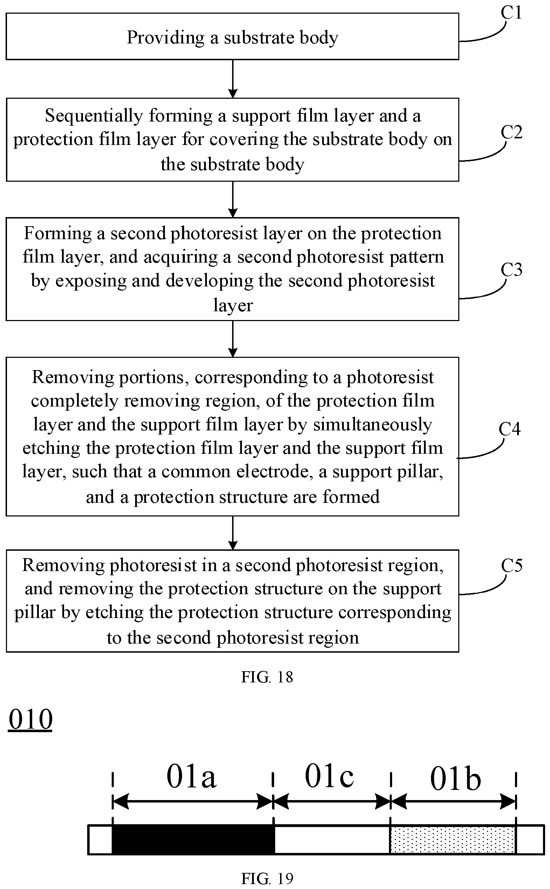

Referring to FIG. 18, FIG. 18 is a flowchart of another method for manufacturing a display substrate according to some embodiments of the present disclosure. The protection structure in the display substrate is formed by the transparent insulative material, and the display substrate includes a common electrode. For example, the display substrate is an array substrate, and the common electrode and the protection structure in the array substrate are formed simultaneously. In this case, the method for manufacturing the display substrate includes the following processes.

In C1, a substrate body is provided.

In the embodiments of the present disclosure, the substrate body is a structure, without a support pillar and a common electrode, in the array substrate.

In C2, a support film layer and a protection film layer for covering the substrate body are sequentially formed on the substrate body.

For details about C2, reference may be made to B2. It should be particularly noted that the protection film layer herein is made of a transparent conductive material.

In C3, a second photoresist layer is formed on the protection film layer, and a second photoresist pattern is acquired by exposing and developing the second photoresist layer.

The second photoresist pattern includes a first photoresist region, a second photoresist region, and a photoresist completely removing region. A thickness of the photoresist in the first photoresist region is greater than a thickness of the photoresist in the second photoresist region, and the photoresist completely removing region does not include the photoresist.

In the embodiments of the present disclosure, the process of forming the second photoresist layer includes: exposing and developing the second photoresist layer by a gray mask plate, such that the photoresist covering the support pillar and the protection structure is reserved, and the photoresist covering the common electrode is reserved, and removing the photoresist in other regions. The photoresist covering the common electrode is the photoresist in the first photoresist region, and photoresist on the support pillar and the protection structure is the photoresist in the second photoresist region.

The photoresist, also known as a liquid photoresist, is the carrier medium for photolithography imaging, and functions as converting diffracted and filtered light information in a photolithography system to chemical energy using the principle of photochemical reaction, such that a mask pattern is copied.

Illustratively, referring to FIG. 19, FIG. 19 is a schematic structural diagram of a gray mask plate according to some embodiments of the present disclosure. The gray mask plate 010 includes a non-transparent region 01a, a semi-transparent region 01b, and a transparent region 01c. A transmittance of the non-transparent region 01a is less than a transmittance of the semi-transparent region 01b, and the transmittance of the semi-transparent region 01b is less than a transmittance of the transparent region 01c. Taking a material of the photoresist layer being a positive photoresist as an example, after the photoresist layer is exposed and developed, the photoresist in the first photoresist region and the second photoresist region is reserved, the photoresist in the photoresist completely removing region is removed, and a thickness of the photoresist in the first photoresist region is greater than a thickness of the photoresist in the second photoresist region. The first photoresist region corresponds to the non-transparent region 01a in the gray mask plate 010, the second photoresist region corresponds to the semi-transparent region 01b in the gray mask plate 010, and the photoresist completely removing region corresponds to the transparent region 01c in the gray mask plate 010.

It should be noted that the embodiments of the present disclosure are illustrated by taking the material of the photoresist thin film being the positive photoresist as an example, and the material of the photoresist thin film is a negative photoresist in some other embodiments, which is not limited in the embodiments of the present disclosure.

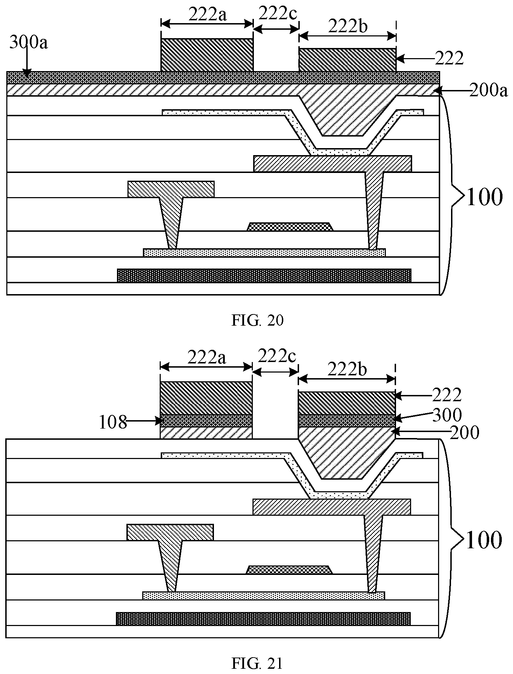

Illustratively, referring to FIG. 20, FIG. 20 is a schematic structural diagram of a display substrate upon completing C3. The photoresist layer 222 is exposed and developed by the gray mask plate 010, such that the photoresist in the first photoresist region 222a and the second photoresist region 222b is reserved, and the photoresist in the photoresist completely removing region 222c is removed. The thickness of the photoresist in the first photoresist region 222a is greater than a thickness of the photoresist in the second photoresist region 222b.

In C4, portions, corresponding to the photoresist completely removing region, of the protection film layer and the support film layer are removed by etching the protection film and the support film layer, such that the common electrode, the support pillar, and the protection structure are formed.

The photoresist in the first photoresist region covers the common electrode, and the photoresist in the second photoresist region covers the protection structure.

In the embodiments of the present disclosure, referring to FIG. 21, FIG. 21 is a schematic diagram of forming a support pillar and a protection structure on a substrate body according to some embodiments of the present disclosure. The first photoresist region 222a covers the common electrode 108, and the second photoresist region 222b covers the protection structure 300 and the support pillar 200.

In C5, the photoresist in the second photoresist region is removed, and the protection structure corresponding to the second photoresist region is etched to remove the protection structure on the support pillar.

In the embodiments of the present disclosure, C5 includes the following processes.

In C501, the photoresist in the second photoresist region 222b is removed and the photoresist in the first photoresist region is thinned by dry etching.

In the present disclosure, the display substrate including the common electrode and the protection structure is placed in a dry etching cavity, and a podzolic gas is introduced, such that the photoresist in the second photoresist region is removed and the photoresist in the first photoresist region is thinned by the podzolic gas. The podzolic gas is reacted with the photoresist to remove the photoresist on the base substrate. For example, the podzolic gas includes a mixture of oxygen and sulfur hexafluoride.

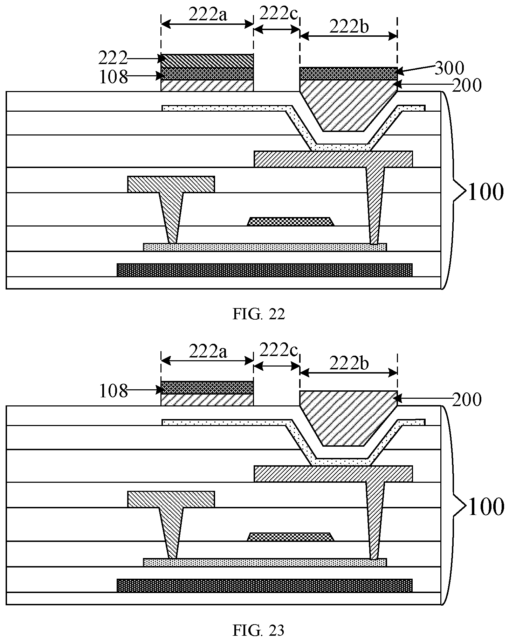

Illustratively, referring to FIG. 22, FIG. 22 is a schematic structural diagram of a display substrate upon completion of C501. The photoresist in the second photoresist region 222b is removed and the photoresist in the first photoresist region 222a is thinned by dry etching. As such, the photoresist is only present in the first photoresist region 222a, and the protection structure 300 of the second photoresist region 222b do not includes the photoresist.

In C502, the support pillar is formed by removing a portion of the protection structure corresponding to the second photoresist region by dry etching.

In the present disclosure, by removing the portion of the protection structure corresponding to the second photoresist region by dry etching, the support pillar is formed in the second photoresist region of the substrate body, and the common electrode is formed in the first photoresist region of the substrate body.

Illustratively, referring to FIG. 23, FIG. 23 is a schematic structural diagram of a display substrate upon completion of C502. The portion of the protection structure 300 corresponding to the second photoresist region 222b is removed by dry etching, such that the support pillar 200 is formed in the second photoresist region 222b of the substrate body 100, and the common electrode 108 is formed in the first photoresist region 222a of the substrate body 100.

In summary, in the method for manufacturing the display substrate in the embodiments of the present disclosure, a support film layer and a protection film layer are sequentially formed on the substrate body, and the one patterning process is performed on the substrate body including the support film layer and the protection film layer once. As the protection structure is formed by the transparent insulative material, and the display substrate includes a common electrode, the support pillar and the common electrode are simultaneously formed by the one patterning process. A face, facing away from the substrate body, of the support pillar is a flat surface. a face, facing away from the substrate body of one display substrate, of the protection structure of the display substrate is efficiently in contact with a face, facing away from the substrate body of the other display substrate, of the protection structure of the other display substrate. As such, the attaching effect of the two display substrates is ensured to be great. In addition, as the support pillar and the common electrode are formed by the one patterning process, the manufacturing process of the display substrate is simplified.

A display device is further provided in the embodiments of the present disclosure. The display device is a product or a component with a display function, such as a mobile phone, a tablet computer, a television, a display, a notebook computer, a digital photo frame, a navigator. The display device includes: a power supply assembly and a display substrate. The display substrate is the display substrate in above embodiments.

In the embodiments of the present disclosure, the display substrate is a display substrate in an organic light emitting diodes display panel or a display substrate in a liquid crystal display panel.

It should be noted that in the accompanying drawings, for clarity of the illustration, the dimension of the layers and regions may be scaled up. It should be understood that when an element or layer is described as being "on" another element or layer, the element or layer may be directly located on other elements or layers, or an intermediate layer may be present. In addition, it should be understood that when an element or layer is described as being "under" another element or layer, the element or layer may be directly located under other elements, or more than one intermediate layer or element may be present. In addition, it should be further understood that when a layer or element is described as being arranged "between" two layers or elements, the described layer or element may be the only layer between the two layers or elements, or more than one intermediate layer or element may be present. In the whole disclosure, like reference numerals indicate like elements.

In the embodiments of the present disclosure, the terms "first" and "second" are used to descriptive purposes, and are not construed to indicate or imply relative importance. Unless expressly limited otherwise, the term "a plurality of" refers to two or more.

Described above are example embodiments of the present disclosure, and are not intended to limit the present disclosure. Any modifications, equivalent replacements, improvements and the like made within the spirit and principles of the present disclosure should be included within the scope of protection of the present disclosure.

## Claims

1. A display substrate, comprising:
a substrate body; and
a plurality of support pillars disposed on the substrate body, wherein the support pillar comprises a first surface in contact with the substrate body, and a second surface opposite to the first surface,
wherein in any direction parallel to the substrate body, a ratio of a width of the first surface to a width of the second surface is greater than or equal to 0.8, and is less than or equal to 1.2.

2. The array substrate according to claim 1, wherein in the any direction parallel to the substrate body, a ratio of an absolute value of a difference value between the width of the first surface and the width of the second surface to the width of the first surface is less than or equal to 0.4.

3. The display substrate according to claim 1, wherein the support pillar comprises: a first portion and a second portion that are laminated in a direction perpendicular to and away from the substrate body, wherein an orthogonal projection of the second portion on the substrate body is within an orthogonal projection of the first portion on the substrate body, a side face of the first portion is a flat surface, and a side face of the second portion is a curved concave surface.

4. The display substrate according to claim 3, wherein the absolute value of the difference value between the width of the first surface and the width of the second surface is less than or equal to 0.8 µm.

5. The display substrate according to claim 3, wherein an included angle between the side face of the first portion and a face, proximal to the substrate body, of the first portion ranges from 85° to 90°.

6. The display substrate according to claim 3, wherein in a direction perpendicular to the side face of the first portion, a maximum depth of the curved concave surface ranges from 0.1 µm to 0.2 µm.

7. The display substrate according to claim 3, wherein in the direction perpendicular to the substrate body, a ratio of a thickness of the second portion to a thickness of the first portion ranges from 1/7 to 1/6.

8. The display substrate according to claim 1, further comprising: a protection structure disposed on a side, facing away from the substrate body, of the support pillar, wherein an orthogonal projection of the support pillar on the substrate body is within an orthogonal projection of the protection structure on the substrate body, and a material of the protection structure is different from a material of the support pillar.

9. The display substrate according to claim 8, wherein a hardness of the material of the protection structure is greater than a hardness of the material of the support pillar.

10. The display substrate according to claim 9, wherein the material of the protection structure comprises an inorganic material, and the material of the support pillar comprises an organic material.

11. The display substrate according to claim 10, wherein the material of the protection structure comprises at least one of a metallic conductive material, a transparent conductive material, and an inorganic insulative material.

12. The display substrate according to claim 7, wherein in the direction perpendicular to the substrate body, a thickness of the support pillar ranges from 0.8 µm to 1.5 µm.

13. The display substrate according to any one of claims 1 to 12, wherein the display substrate is an array substrate, and the substrate body comprises: a first base, and a thin-film transistor, a flattening layer, a pixel electrode, and an auxiliary support pillar that are disposed on the first base; wherein
the thin-film transistor is provided with a source and a drain;
the flattening layer is disposed on a side, facing away from the first base, of the thin-film transistor, and is provided with a connection via hole, and at least a portion of the source or the drain is disposed in the connection via hole;
the pixel electrode is disposed on a side, facing away from the first base, of the flattening layer, and a portion of the pixel electrode is disposed in the connection via hole and is in contact with the source or the drain; and
the support pillar is disposed outside the connection via hole, the support pillar and the auxiliary support pillar are integrally formed, and the auxiliary support pillar is disposed in the connection via hole.

14. The display substrate according to claim 12, wherein in a direction perpendicular to the first base, a height H of the support pillar and a width W of a face, facing away from the first base, of the support pillar meets: 1/5W≤H≤ 1/2W.

15. The display substrate according to claim 13, wherein
the thin-film transistor is further provided with an active layer in contact with the source and the drain; and
the substrate body further comprises: a light blocking structure disposed on a side, proximal to the first base, of the thin-film transistor, and a buffer layer disposed between the light blocking structure and the thin-film transistor;
wherein an orthogonal projection of the active layer on the first base is within an orthogonal projection of the light blocking layer on the first base, and an orthogonal projection of the support pillar on the first base is within the orthogonal projection of the light blocking structure on the first base.

16. The display substrate according to claim 13, wherein the substrate body further comprises: a passivation layer disposed on a side, facing away from the first base, of the pixel electrode, and a common electrode disposed on a side, facing away from the first base, of the passivation layer; wherein
a portion of the passivation layer is disposed in the connection via hole, and in the connection via hole, the support pillar is disposed on a side, facing away from the first base, of the passivation layer; and
an orthogonal projection of the common electrode on the first base is not overlapped with an orthogonal projection of the connection via hole on the first base.

17. The display substrate according to any one of claims 14 to 16, wherein the source and the drain in the thin-film transistor are disposed on different layers.

18. The display substrate according to claim 13, wherein the width of the face, facing away from the first base, of the support pillar is less than or equal to 4.5 µm.

19. The display substrate according to any one of claims 1 to 12, wherein the display substrate is a color film substrate, and the substrate body comprises: a second base, and a color resistance layer and a black matrix that are disposed on the second base;
wherein the support pillar is disposed on a side, facing away from the second base, of the black matrix, and an orthogonal projection of the support pillar on the second base is within an orthogonal projection of the black matrix on the second base.

20. The display substrate according to claim 19, wherein a width of a face, facing away from the second base, of the support pillar is less than or equal to 2 µm.

21. A method for manufacturing a display substrate, comprising: forming a plurality of support pillars on a substrate body, wherein the support pillar comprises a first surface in contact with the substrate body, and a second surface opposite to the first surface;
wherein in any direction parallel to the substrate body, a ratio of a width of the first surface to a width of the second surface is greater than or equal to 0.8, and is less than or equal to 1.2.

22. The method according to claim 21, wherein forming the plurality of support pillars on the substrate body comprises:
sequentially forming a support film layer and a protection film layer for covering the substrate body on the substrate body, wherein an etching rate on a material forming the protection film layer is less than an etching rate on a material forming the support film layer; and
acquiring the support pillar from the support film layer and a protection structure from the protection film layer by simultaneously patterning the support film layer and the protection film layer;
wherein an orthogonal projection of the support pillar on the substrate body is within an orthogonal projection of the protection structure on the substrate body.

23. The method according to claim 22, further comprising:
removing the protection structure upon simultaneously patterning the support film layer and the protection film layer.

24. A display device, comprising: a power supply assembly, and the display substrate as defined in any one of claims 1 to 20; wherein the power supply assembly is configured to supply power to the display substrate.
